# FASCICULE DE BREVET EUROPEEN

(11) **EP 4 233 491 B1**
(45) Date de publication et mention de la délivrance du brevet: **04.12.2024**
(21) Numéro de dépôt: 21811410.6
(22) Date de dépôt: 25.10.2021
(51) Int. Cl.: H05B 6/14, H05B 6/36, F27B 14/06, F27D 11/06

(54) **BLINDAGE ELECTROMAGNETIQUE COMPACT ET LEGER POUR INDUCTEUR A FORTE PUISSANCE**
KOMPAKTE UND LICHT-ELEKTROMAGNETISCHE ABSCHIRMUNG FÜR EINEN HOCHLEISTUNGSINDUKTOR
COMPACT AND LIGHT ELECTROMAGNETIC SHIELDING FOR A HIGH POWER INDUCTOR

(30) Priorité: 23.10.2020 FR 2010884
(43) Date de publication de la demande: 30.08.2023
(73) Titulaire: Orano Recyclage, 92320 Châtillon (FR); Commissariat à l'Energie Atomique et aux Energies Alternatives, 75015 Paris (FR)
(72) Inventeur: ROUSSET, Etienne, 50110 CHERBOURG-EN-COTENTIN (FR); QUIDOR, Gilles, 14400 RANCHY (FR); BRUN, Patrice, 30200 SAINT-MICHEL D'EUZET (FR)
(74) Mandataire: Brevalex
(86) Numéro de dépôt international: PCT/FR2021/051871
(87) Numéro de publication internationale: WO 2022/084641

(56) Documents cités:
- FR-A1- 2 548 856
- US-A- 6 011 246
- US-A1- 2011 204 042

## Description

La présente invention concerne un inducteur électromagnétique blindé, apte à fonctionner à hautes fréquences d'induction, avec une puissance réactive élevée et éventuellement dans un environnement à forte irradiation ionisante, sans que des applications plus générales en soient exclues. L'inducteur de l'invention est doté d'un blindage électromagnétique amélioré surtout quant à l'encombrement, à la masse et à la préservation des paramètres électriques de la charge. Il peut équiper un four de fusion doté d'une charge solide.

La gestion du champ magnétique dans les systèmes à induction fait l'objet d'un certain nombre de brevets et publications scientifiques. Les applications existent à des échelles très différentes : de micro-composants électroniques à des fours industriels de plusieurs mètres. Un confinement du champ magnétique à l'aide d'un dispositif de type blindage autour de la source peut être utile pour améliorer les performances électrotechniques du système ou assurer une immunité vis-à-vis du rayonnement électromagnétique entre le système et son environnement extérieur. Dans ce deuxième cas, le blindage permet d'éviter des perturbations électromagnétiques et leurs conséquences telles que des forces électromotrices ou des échauffements indésirables, des arcs électriques, des interférences électromagnétiques et des problèmes de compatibilité électromagnétique entre appareils électriques ainsi que des risques de perturbation des organismes vivants. Les blindages électromagnétiques passifs usuels consistent en une enveloppe métallique ou bien en des concentrateurs de champ en matériaux de forte perméabilité magnétique dits ferromagnétiques (matériaux capables d'attirer et de canaliser le champ magnétique). Les enveloppes métalliques sont principalement utilisées lorsque le rayonnement électromagnétique a une faible puissance et une fréquence élevée. Cette solution est bien adaptée à des équipements électroniques. Pour les dispositifs comportant un inducteur produisant un champ magnétique de forte amplitude, cette solution engendre trop de mutuelle inductance entre l'inducteur et l'enveloppe ce qui oblige à garder une certaine distance entre ces deux éléments pour ne pas diminuer le rendement de l'inducteur et pour ne pas surchauffer l'enveloppe ou lui adjoindre un nouveau dispositif de refroidissement. L'encombrement résultant du blindage avec enveloppe métallique peut alors s'avérer incompatible avec les contraintes d'intégration.

Les concentrateurs de champ sont utilisés pour limiter les fuites de champ dont la fréquence est trop basse pour une enveloppe métallique (leur profondeur de pénétration est trop grande) ou pour améliorer l'efficacité d'un composant électrique. Pour les applications fonctionnant jusqu'à quelques dizaines de kilohertz (transformateurs sur le réseau électrique, fours industriels pour la fusion de métaux par exemple), les concentrateurs classiquement utilisés se composent d'un feuilleté de fer laminé et d'isolant électrique. Pour les applications fonctionnant à plus haute fréquence, on utilise des pièces massives ferromagnétiques. On est alors confronté à diverses difficultés de réalisation. Tout d'abord, les pertes thermiques dans les concentrateurs de champ habituels sont très importantes pour un usage à fréquence et puissance réactive élevées telles que dans le domaine principalement envisagé (supérieure à 100 kHz, et de l'ordre de 300 kHz ; supérieure à 1 Mvar, et de l'ordre de 12 Mvar). Ces pertes thermiques peuvent être d'ailleurs amplifiées par des phénomènes de résonance magnétique susceptibles d'apparaître dans des matériaux ferromagnétiques usuels tels les ferrites doux, obtenus par moulage et compactage de poudres à base d'oxydes de fer ou d'autres métaux, quand ces pièces atteignent des dimensions centimétriques. Les ferrites adaptés aux gammes de fréquence supérieures à 100 kHz (à base de Zn et Mn, Ni ou Mg par exemple) sont d'ailleurs des matériaux délicats à usiner à cause de leur grande dureté et fragilité. Leur intégration sur des équipements de grande dimension ou à géométrie complexe est donc particulièrement difficile. Les ferrites doux sont ainsi surtout utilisés dans des formats génériques comme absorbeurs des perturbations électromagnétiques sur les câbles ou dans les petits transformateurs et les inductances de circuits électroniques, et beaucoup moins dans les systèmes de chauffage par induction.

D'autres matériaux ferromagnétiques envisageables sont des composites, dits ferrites liés, qui comportent un liant isolant électrique organique (par exemple du PTFE) entre des grains de poudre de fer. L'intérêt d'employer de tels matériaux pour le chauffage par induction est bien documenté. Ils ont le grand avantage d'être plus facilement usinables. Néanmoins, les ferrites liés dissipent plus de pertes thermiques que les ferrites doux et ne sont pas compatibles avec un fort rayonnement ionisant car l'isolant qu'ils contiennent est organique.

Un bon confinement du champ magnétique par des concentrateurs de champ impliquerait enfin, dans les applications particulièrement envisagées ici, une masse et un encombrement tout à fait excessifs, à cause entre autres de la quantité à mettre en oeuvre ou de la nécessité de les refroidir par des circuits dédiés de fluide de refroidissement.

D'autre part, les inducteurs munis de concentrateurs de champ usuels sont construits avec un bobinage composé de plusieurs spires en série, faisant chacune un tour de la charge à chauffer. Pour les applications de forte puissance (> 1 Mvar de puissance réactive) et fréquence élevée (> 100 kHz), les spires en série imposent une tension trop élevée, qui rend nécessaire d'utiliser une spire unique (bobinage faisant un seul tour) pouvant être composée de plusieurs brins d'inducteur alimentés en parallèle. Le problème d'un montage en parallèle est que la répartition du courant se fait préférentiellement sur les régions ou les brins périphériques, ce qui engendre des échauffements non uniformes dans l'inducteur, le champ magnétique rayonné et l'induction dans la charge sont également moins uniformes. Si des concentrateurs de champ sont installés près d'un inducteur à brins parallèles, ces hétérogénéités sont renforcées. C'est pourquoi les concentrateurs de champ sont surtout adaptés aux inducteurs à spires en série.

Une dernière difficulté à considérer est que les concentrateurs de champ comme les enveloppes métalliques placés à proximité de l'inducteur modifient les paramètres électriques de la charge vue par la source de puissance, ce qui peut rendre impossible l'intégration d'un blindage sur une installation existante sans réaliser des modifications importantes sur le générateur ou les conducteurs électriques.

US 5 197 081 A décrit un four à induction pourvu d'un blindage électromagnétique destiné à dévier les lignes de champ qui seraient fortement incurvées vers l'extérieur sans lui, et atteindraient une enveloppe extérieure en y développant des courants induits et des pertes thermiques. Le blindage consiste en des boucles à structure feuilletée, composées de couches ferromagnétiques alternant avec des couches isolantes ; toutes ces couches se bouclent sur elles-mêmes, les premières dévient les lignes de champ et les secondes empêchent des échauffements excessifs dans le blindage. Le champ n'atteint pas l'enveloppe extérieure, qui ne contribue donc pas au blindage, et aucun refroidissement du blindage ferromagnétique n'est nécessaire. Mais la structure feuilletée ne convient pas à des puissances et fréquences élevées.

US 5 588 019 A décrit un four à induction dont le bobinage inducteur est complètement enveloppé (du côté radialement extérieur) par un concentrateur de champ continu en composite de poudre de fer et de polymère de liaison. L'emploi de ces matériaux n'est pas apprécié dans l'invention à cause des pertes excessives qu'ils suscitent aux hautes puissances. Un refroidissement, qui est autant que possible évité dans l'invention, est prévu pour ce blindage. Il n'y a pas d'enveloppe extérieure mais une structure d'assemblage très aérée.

JP H8 155 591 A décrit un four à induction pourvu d'un blindage pouvant être en ferrite et sectorisé dans la direction angulaire du four, c'est-à-dire qu'il se compose de colonnes séparées les unes des autres en embrassant chacune une portion de circonférence du four ; cette disposition empêche des courants induits de se former dans le blindage. De tels dispositifs à colonnes continues, ayant pour objectif de capter le maximum de champ magnétique, sont en soi incompatibles avec l'application particulièrement envisagée ici car ils entraîneraient un flux magnétique, et donc des pertes thermiques, trop élevés dans le blindage. Ici non plus il ne semble pas y avoir d'enveloppe extérieure continue autour du four et du concentrateur de champ, mais une simple structure d'assemblage ou une semelle de fixation. Le problème technique principal résolu par ce document consiste à arrêter le champ magnétique dans la direction axiale, grâce à des plaques conductrices circulaires planes de fond et de sommet sur lesquelles les extrémités du concentrateur de champ s'appuient, afin de ne pas laisser un long conduit servant de creuset dévier les lignes de champ hors du lieu de chauffage.

US 2011/204042 A1 divulgue un inducteur électromagnétique blindé selon le préambule de la revendication 1.

Le but de l'invention est d'assurer le confinement d'un champ magnétique pouvant être produit par un inducteur de forte puissance fonctionnant à une fréquence élevée avec un dispositif :
- assurant un niveau de confinement élevé pour un champ inductif pouvant être de quelques dixièmes de millitesla à quelques millitesla à une fréquence pouvant être de l'ordre de 100 kHz à 1MHz, par exemple de 300 kHz,
- ayant une température maîtrisée sans circuit de refroidissement additionnel,
- compact et limité en masse,
- limitant le décalage des paramètres électriques par rapport à une configuration sans blindage, afin de permettre l'intégration du blindage à une installation existante de four sans aucune modification de la source de puissance, ou avec des modifications réduites,
- pouvant être fabriqué à l'aide de moyens industriels classiques,
- conservant une bonne homogénéité de l'induction dans le volume de la charge, surtout dans la direction longitudinale de l'inducteur,
- ayant une longévité de plusieurs années avec un usage industriel intensif, avec une maintenance réduite ou inexistante et dans un environnement à forte radioactivité.

Une application particulière visée par l'invention est le chauffage par induction en creuset froid pour la vitrification de déchets nucléaires.

Sous une forme générale, l'invention concerne un inducteur électromagnétique blindé, comprenant un inducteur disposé devant une charge à chauffer par induction électromagnétique et composé d'au moins une spire conductrice, où du courant circule dans une direction de longueur de spire, et un blindage électromagnétique comprenant un concentrateur de champ magnétique disposé devant l'inducteur avec l'inducteur situé entre ledit concentrateur et la charge, ledit concentrateur comprenant des colonnes ferromagnétiques dont une direction principale d'allongement coïncide avec une direction d'une composante principale de lignes de champ magnétique propagées par l'inducteur d'un côté orienté vers le concentrateur, les colonnes étant séparées les unes des autres par un milieu isolant électrique et embrassant chacune une portion de longueur de spire de l'inducteur, caractérisé en ce que les colonnes sont composées d'éléments ferromagnétiques se succédant dans ladite direction d'allongement des colonnes et séparés par des espacements isolants électriques, de plus faible perméabilité magnétique et de plus petite longueur que les éléments ferromagnétiques dans ladite direction d'allongement, et en ce que le blindage électromagnétique comprend encore une enveloppe conductrice de l'électricité, le concentrateur de champ étant situé entre l'enveloppe et l'inducteur.

Ces espacements peuvent être constitués soit d'un matériau isolant électrique soit d'un vide d'air.

Il est précisé que le terme « ferromagnétique » couvre la propriété des matériaux à attirer le champ magnétique, c'est-à-dire avec une perméabilité magnétique relative supérieure à 1.

Par rapport à certaines conceptions connues où le concentrateur de champ est sectorisé parallèlement aux lignes de champ, celui de l'invention l'est aussi perpendiculairement aux lignes de champ, avec deux effets principaux. Le premier est que, par rapport aux conceptions classiques où les concentrateurs de champ sont continus dans l'alignement des lignes de champ magnétique, le flux magnétique capté par les colonnes est plus faible, de façon que les pertes thermiques sont nettement réduites dans le concentrateur et que le refroidissement n'est pas forcément nécessaire ou qu'il peut être accompli sans dispositif additionnel de circulation de fluide, comme on le verra plus loin. Le second est que le couplage inductif résiduel avec l'enveloppe extérieure conductrice est accru, d'une manière qui réduit l'effet perturbateur du blindage sur les paramètres électriques de l'installation vus de la source de puissance lorsque le blindage doit être ajouté à une installation existante, et qui permet donc d'ajouter ce blindage sans modification importante ailleurs dans l'installation.

Les éléments ferromagnétiques sont avantageusement en ferrite doux, sans liant en polymère ni autre matériau composite. L'usinage d'éléments massifs, en forme de blocs ou de tuiles, de ferrite convenables pour les fortes puissances, comme ceux qui sont à base de Mn et Zn, et qui est jugé difficile, est toutefois réalisable dans de bonnes conditions par une découpe au jet d'eau.

Le blindage comprend une enveloppe, conductrice de l'électricité, disposée devant les colonnes ferromagnétiques du côté opposé à l'inducteur. Le blindage principal procuré par les colonnes du concentrateur de champ est alors renforcé par un blindage électromagnétique qui arrête le champ résiduel ayant échappé au blindage principal ferromagnétique, et contribue à neutraliser l'effet global du blindage sur les paramètres électriques de l'installation. L'épaisseur de l'enveloppe est largement supérieure à la profondeur de pénétration caractéristique du champ, de sorte que le champ magnétique pouvant passer au travers de l'enveloppe est complètement négligeable. Les courants induits dans l'enveloppe étant modérés grâce à la faiblesse du champ résiduel, et les pertes thermiques dans le blindage principal et rayonnant hors de lui étant réduites grâce à la constitution sectorisée par les espacements, l'enveloppe peut être proche, sans toutefois être au contact électrique, des colonnes ferromagnétiques. L'encombrement radial du dispositif est réduit sans nécessité de refroidissement, le risque de surchauffe étant écarté.

Grâce aux effets antagonistes sur l'inductance de charge et la résistance de charge des deux constituants du blindage combiné, il est avantageux, et facile à obtenir, que ces constituants soient élaborés pour que les paramètres de résistance et d'inductance de l'installation vus depuis la source d'alimentation électrique aient des valeurs qui diffèrent de moins de ±10 %, par exemple, de valeurs respectives desdits paramètres qui seraient constatées en l'absence du blindage.

Dans une réalisation ou une application particulièrement envisagée de l'invention, l'inducteur a une forme de révolution autour de la charge et autour d'un axe (généralement vertical), de sorte que la direction d'allongement des colonnes coïncide avec la direction de l'axe et l'enveloppe conductrice de l'électricité comprend une portion qui entoure le concentrateur de champ. D'autres configurations du four sont possibles, et l'une d'elles sera brièvement décrite pour ce texte.

Avantageusement, l'épaisseur des espacements est ajustée de façon à augmenter la réluctance magnétique totale du blindage d'un facteur 20 à 80 par rapport à une configuration sans espacements et ainsi jouir pleinement des effets de la sectorisation verticale. L'épaisseur idéale des espacements, apte à procurer une telle amélioration, dépend de la section des colonnes et des blocs ferromagnétiques.

Du moins pour le domaine des puissances et fréquences élevées, l'inducteur sera généralement à spire unique et composé de brins montés électriquement en parallèle. On pourra alors préférer un agencement où les brins se composent de portions inclinées verticalement, alternativement descendantes et ascendantes et réparties en deux nappes circulaires, concentriques et s'étendant à des hauteurs identiques suivant l'axe, une première des nappes comprenant toutes les portions ascendantes et une seconde des nappes toutes les portions descendantes : une telle construction de l'inducteur réduit les effets de bord, c'est-à-dire les écarts d'intensité de courant entre les brins et les irrégularités d'induction en hauteur, surtout aux extrémités haute et basse de l'inducteur. Une configuration plus avantageuse, vis-à-vis des pertes dans les ferrites et du décalage des paramètres électriques, est d'avoir plusieurs espacements répartis le long de la colonne plutôt qu'un seul espacement plus large. Il peut se révéler avantageux d'appliquer, pour de tels inducteurs à spire unique, une disposition où les blocs ferromagnétiques s'étendent chacun devant un seul des brins de l'inducteur (ou une seule des portions descendantes ou ascendantes de celle des nappes qui est radialement plus à l'extérieur, si la spire est composée desdites portions dans lesdites nappes concentriques), afin de limiter les risques de conduction électrique entre brins adjacents, surtout dans les constructions détaillées ci-dessous où les blocs sont reliés à l'inducteur.

Une construction remarquable, apte à simplifier la fabrication du four avec une bonne précision de ses dimensions, ainsi qu'une bonne qualité de fonctionnement, apparaît si certaines au moins des caractéristiques suivantes sont présentes :
- Les ferrites (éléments ferromagnétiques) sont mécaniquement liés à l'inducteur afin de bénéficier de son support mécanique et de son éventuelle source de refroidissement. Les supports sont alors avantageusement conducteurs thermiques. Les ferrites bénéficient du refroidissement de l'inducteur peuvent plus facilement se passer de dispositif de refroidissement propre.
- Le maintien des ferrites est réalisé par collage ou dispositif d'attache tel que des vis, clips ou autres.
- Une couche de liant conducteur thermique est conseillée sur les surfaces de ferrites au contact de la source de refroidissement.
- Un intermédiaire en matériau isolant électrique est fortement conseillé (mais pas obligatoire dans tous les cas) entre les ferrites et tout autre pièce conductrice électrique en appui contre les ferrites, en particulier les pièces soumises à des forces électromotrices importantes telle que l'inducteur, afin de nettement diminuer les pertes Joule dans les ferrites et éviter le risque de court-circuit au travers des ferrites. Les éléments de maintien des ferrites ne contribuant pas au refroidissement mais en appui sur les ferrites, tels que des vis ou d'autres systèmes d'attaches, sont de préférence entièrement en matériau isolant électrique.
- Certaines colles époxy permettent de satisfaire simultanément aux deux points précédents en plus d'être faiblement dégradées par les rayonnements ionisants.
- Des pièces dites adaptatives dans un matériau à haute conductivité thermique comme du métal, peuvent être intercalées entre les ferrites et l'inducteur si une bonne conduction de chaleur est souhaitée. Une autre fonction des pièces adaptatives est cependant de faciliter la liaison des éléments ferromagnétiques à l'inducteur même si leurs formes sont différentes, par exemple si les éléments ferromagnétiques sont plats alors que l'inducteur est de révolution. Les pièces adaptatives pourront avoir un premier côté ayant une courbure identique à l'inducteur et un deuxième côté, opposé au premier côté, sur lequel au moins un élément ferromagnétique est installé et qui a une courbure identique auxdits éléments ferromagnétiques installés.
- Les pièces adaptatives peuvent être maintenues à l'inducteur par un liant conducteur thermique type brasure (si supports métalliques) ou colles époxy susmentionnées ou par d'autres moyens d'attaches comme des vis, boulons, goujons, clips ou autres.

Une caractéristique avantageuse de construction consiste en ce que les supports ont une extension moindre que les éléments ferromagnétiques dans la direction d'allongement des colonnes, et les éléments ferromagnétiques ont des bords extrêmes dans la direction d'allongement qui sont dégagés des supports. Cela est valable surtout si les supports comprennent des pièces adaptatives conductrices de l'électricité, afin, ici aussi, d'éviter des pertes d'énergie électromagnétique.

On préfère éviter des angles vifs sur les éléments ferromagnétiques, afin d'éviter encore des pertes d'énergie électromagnétique par effet de pointe. Dans un cas usuel où les éléments seront en forme de blocs ou de tuiles quadrangulaires plats, il pourrait être avantageux de les chanfreiner à au moins certains coins du quadrangle.

Un aspect avantageux de l'invention est que l'enveloppe conductrice peut être fortement rapprochée du concentrateur de champ. Si cette distance est rendue très petite, il peut toutefois être avantageux de disposer d'une couche d'isolant électrique entre l'enveloppe conductrice et le concentrateur de champ.

Un avantage important de l'invention est l'efficacité et la légèreté du blindage électromagnétique, au point qu'il est envisageable que le blindage ait une masse inférieure à celle de l'inducteur.

Un autre aspect de l'invention est une utilisation particulièrement envisagée - mais pas exclusive - de cet inducteur électromagnétique blindé dans un four pour vitrifier des déchets nucléaires.

On passe maintenant au commentaire détaillé d'une réalisation particulière et purement illustrative de l'invention, afin de saisir les divers aspects, caractéristiques et avantages de celle-ci, au moyen des figures suivantes :
[Fig. 1] : une vue d'ensemble du dispositif d'inducteur blindé ;
[Fig. 2] : première réalisation du concentrateur de champ ferromagnétique ;
[Fig. 3] : deuxième réalisation ;
[Fig. 4] : troisième réalisation ;
[Fig. 5] : quatrième réalisation ;
[Fig. 6] : détail de réalisation des éléments ferromagnétiques ;
[Fig. 7] : vue de face de supports des éléments ferromagnétiques ;
[Fig. 8] : vue de dessus d'un des supports ;
[Fig. 9] : vue en coupe verticale partielle de l'inducteur avec le blindage ;
[Fig. 10] : vue d'une autre réalisation possible de l'inducteur blindé ;
[Fig. 11] : diagramme de paramètres électriques ;
[Fig. 12] : diagramme de pertes thermiques.

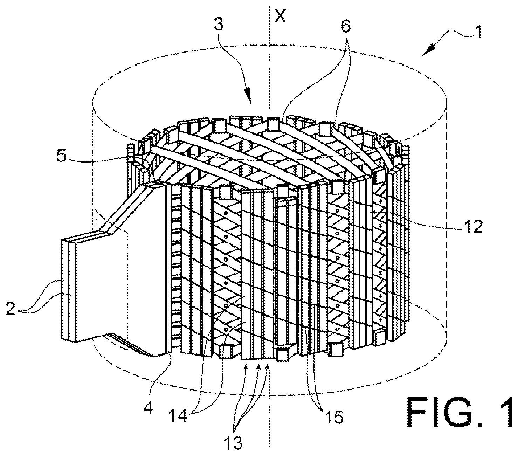

La figure 1 illustre l'inducteur blindé vu de l'extérieur. Sa forme générale est de révolution et cylindrique d'axe vertical X et ouverte vers le haut dans cette réalisation, et il est entouré par une enveloppe extérieure 1 métallique et conductrice de l'électricité qui sert au blindage électromagnétique. L'enveloppe extérieure 1 comprend une paroi circonférentielle presque continue, d'où sortent cependant les raccords d'entrée et de sortie 2 par lesquels un inducteur 3 est alimenté en électricité et en fluide de refroidissement. Elle est éventuellement complétée par des parois de fond et de sommet pour isoler plus l'inducteur de l'extérieur. Elle peut être métallique, en alliage de cuivre ou d'aluminium. L'inducteur 3 est mieux visible sur les figures suivantes 2 à 5 qu'on aborde à présent. Il est formé d'une spire unique de forme complexe qui entoure par exemple la charge à chauffer, qui peut être contenue dans un creuset, qui peut lui-même être un creuset dit froid. Les creusets froids, utilisés pour la vitrification de déchets nucléaires qui constitue une application envisagée pour l'invention, sont refroidis par une circulation interne de liquide et produisant une solidification superficielle, apte à les protéger de la corrosion, de la charge à leur contact. Les raccords d'entrée et de sortie 2 aboutissent à deux collecteurs 4 et 5 qui sont des lames conductrices allongées en hauteur, proches l'une de l'autre et qui sont les extrémités de l'inducteur 3. La spire inductrice est composée de brins 6 conducteurs tous raccordés aux collecteurs 4 et 5 et qui sont donc montés électriquement en parallèle en faisant un tour unique du four. Chaque brin 6 est de forme zigzagante et composé essentiellement de portions dites ascendantes 7 alternant avec des portions dites descendantes 8 dotées d'inclinaisons verticales opposées. Toutes les portions ascendantes 7 et descendantes 8 s'étendent du niveau le plus bas au niveau le plus haut de l'inducteur 3. Les portions ascendantes 7 croisent donc les portions descendantes 8, mais sans les toucher puisqu'elles s'étendent dans des nappes cylindriques concentriques et séparées, les portions (conventionnellement) ascendantes 7 dans une nappe intérieure 9 et les portions (conventionnellement) descendantes 8 dans une nappe extérieure 10. En effet, les brins 6 comprennent encore des raccords 11 courts et dirigés radialement, qui relient chaque portion ascendante ou descendante aux portions voisines du brin 6. Cette disposition, déjà connue d'après le document WO 2007/031564 A1, est préférée ici car elle réduit les hétérogénéités d'induction dans la hauteur et surtout les concentrations de courant aux bords supérieur et inférieur de l'inducteur 3 dites ici effets de bord. Enfin, les collecteurs 4 et 5 ainsi que les brins 6 sont creux et parcourus par un fluide de refroidissement, semblable à celui qui est décrit dans ce document.

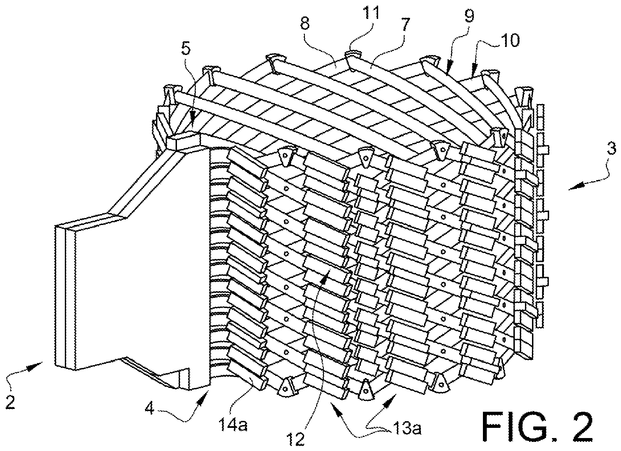

Le four comprend un blindage électromagnétique principal qui est un concentrateur de champ 12 magnétique et qui s'étend, avec une forme générale annulaire, entre l'inducteur 3, radialement à l'intérieur de lui, et l'enveloppe extérieure 1, radialement à l'extérieur de lui. Il est composé de colonnes 13 verticales (dressées dans la direction de l'axe X) embrassant chacune un secteur de circonférence du four mais séparées les unes des autres et formées d'éléments ferromagnétiques qui sont ici des blocs ferromagnétiques 14 (aussi désignés par 14a, 14b, 14c ou 14d sur les figures 2 à 5) parallélépipédiques, ou des tuiles plates quadrangulaires, de ferrite superposés dans la direction verticale, mais séparés par des espacements 15 isolants électriques et amagnétiques intercalés entre eux. Les espacements 15 peuvent être des espaceurs matériels maintenant la continuité des colonnes 13, ou bien des espaces vides, ce qui est permis si les blocs 14 sont soutenus indépendamment les uns des autres. Le concentrateur de champ 12 a pour fonction de canaliser les lignes de champ magnétique extérieures à l'inducteur 3 pour concentrer le champ magnétique à l'intérieur d'un périmètre réduit, conserver ou augmenter ainsi les courants induits dans la charge à chauffer et conserver ou accroître le rendement thermique du four, tout en limitant partiellement le couplage inductif avec l'enveloppe périphérique 1 qui finit de bloquer vers l'extérieur les fuites de champ magnétique. Avec l'enveloppe 1, il compose le blindage électromagnétique d'ensemble de l'installation. Les blocs ferromagnétiques 14 peuvent avoir jusqu'à quelques centimètres de haut, quelques degrés d'extension angulaire (de préférence inférieure à 15°), et les espacements 15 quelques dixièmes de millimètres à quelques millimètres de haut. L'extension des blocs ferromagnétiques 14 en direction radiale est restreinte pour faciliter leur refroidissement par l'inducteur 3 de la façon qu'on indiquera plus loin, alors que les blocs ferromagnétiques 14 sont dépourvus de circuit de fluide de refroidissement qui leur serait spécifiquement associé. Leur extension en direction angulaire est aussi restreinte, afin de limiter les résonances magnétiques. De plus, on préconise que chaque bloc ferromagnétique 14 s'étende devant un seul brin 6, afin de limiter les risques de conduction électrique dans le concentrateur de champ 12 entre brins 6 adjacents ; avec l'inducteur 3 composé de portions zigzagantes se croisant, ce principe est appliqué en faisant que chaque bloc ferromagnétique 14 s'étende devant une seule portion (ici dite descendante 8) de la nappe extérieure 10, qui leur est contiguë.

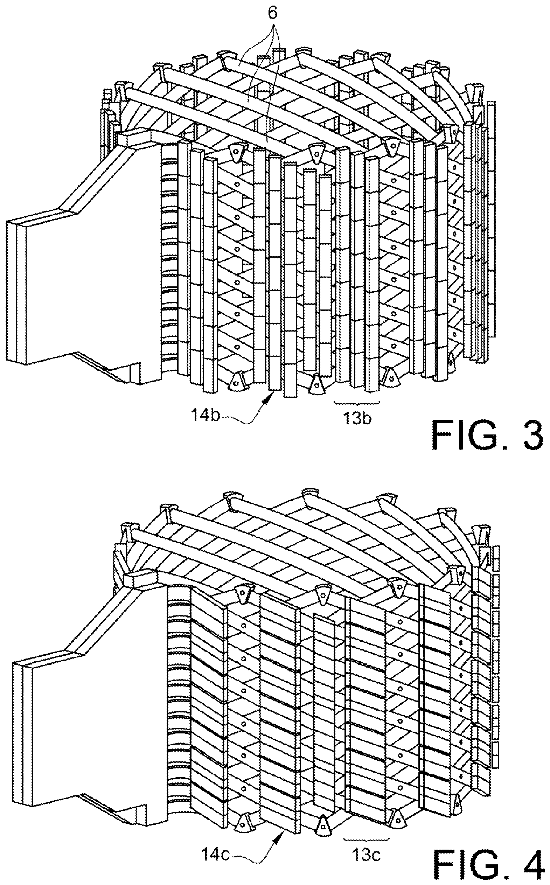

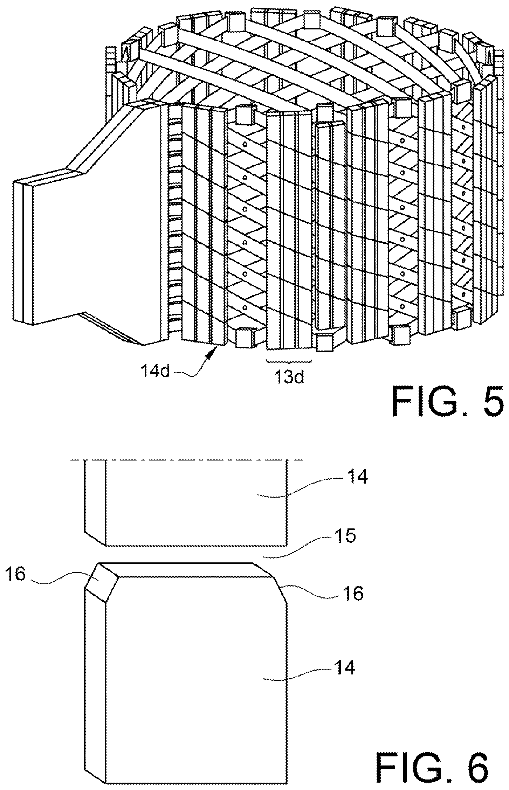

Plusieurs variantes de réalisation peuvent alors être envisagées, en considérant que la section et le nombre de colonnes 13 peuvent être variés, afin d'optimiser la canalisation du flux et les effets de résonnance magnétique et que les extrémités des blocs ferromagnétiques 14 peuvent être ajustées de différentes manières, en fonction des facilités de montage souhaité et de l'optimisation de la masse de ferrite. Dans la figure 2, les blocs ferromagnétiques 14a sont en forme de parallélépipèdes, ou de tuiles rectangulaires, inclinés comme les brins 6, ce qui produit des colonnes 13a dont les bords latéraux sont irréguliers en lignes brisées ; à la figure 3, les blocs ferromagnétiques 14b sont encore des tuiles rectangulaires, mais avec leur côté vertical, une plus petite extension angulaire que dans le cas précédent, mais une plus grande extension verticale ; chacune des colonnes 13b est composée alors de plusieurs empilements juxtaposés de blocs ferromagnétiques 14b, et les bords supérieurs de ces colonnes 13b sont en escalier. Le dispositif de la figure 4 est analogue à celui de la figure 2, si ce n'est que les tuiles rectangulaires sont remplacées par des tuiles en trapèzes, de façon que les blocs magnétiques 14c donnent des colonnes 13c dont les côtés latéraux sont verticaux et réguliers. Enfin, l'agencement de la figure 5 est analogue à celui de la figure 3, si ce n'est qu'ici aussi les tuiles rectangulaires sont remplacées par des tuiles trapézoïdales dont l'inclinaison des bords supérieurs et inférieurs est semblable à celles des brins 6 et à angle droit avec les côtés latéraux aux extrémités des colonnes 13d, ce qui donne des bords rectilignes aux colonnes 13d. Dans chacun de ces agencements, on peut envisager de casser les angles vifs des blocs ferromagnétiques 14 en y opérant des chanfreins ou des congés de raccordement entre côtés, car des effets de pointes, ayant pour conséquence de fortes concentrations du champ magnétique et des pertes localisées, risquent d'apparaître à ces endroits. Une réalisation possible est représentée à la figure 6, où les chanfreins portent le repère 16.

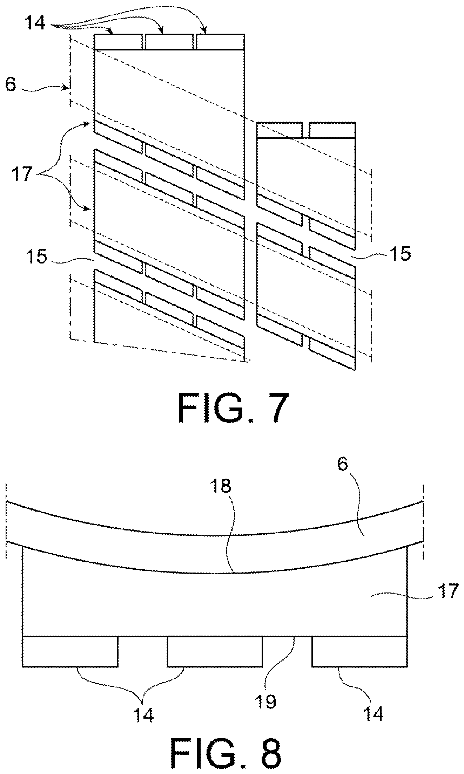

Il est envisagé que les blocs ferromagnétiques soient soutenus par l'inducteur. Le support peut éventuellement être direct, si les brins 6 de l'inducteur et les blocs ferromagnétiques 14 ont des faces de formes complémentaires permettant de les assembler directement par collage ou autrement. Cela peut toutefois soulever des problèmes importants, à cause de la difficulté de façonner les ferrites à des formes complexes ou de remplacer les inducteurs traditionnels de forme simple et régulière de révolution par d'autres. Si un support direct est exclu, les brins 6 pourront soutenir les blocs ferromagnétiques 14 par des supports 17 (et non représentés sur les figures précédentes) représentés sommairement à la figure 7, en forme de plaques, et qui, d'après la figure 8 seront des pièces adaptatives de forme entre les brins 6 et les blocs ferromagnétiques 14 et auront une section de forme irrégulière, un côté intérieur 18 ayant une courbure semblable à celle des brins 6 et un côté extérieur 19 étant plat si les blocs ferromagnétiques 14 sont des tuiles plates, ou, plus généralement, ayant une courbure identique à celle des blocs ferromagnétiques 14. Une telle disposition permet de plaquer les brins 6 et les blocs ferromagnétiques 14 sur les supports 17 et facilite donc la cohésion de l'ensemble. La figure 7 montre que l'extension verticale des supports 17 est avantageusement inférieure à celle des blocs ferromagnétiques 14 pour que les blocs ferromagnétiques 14 débordent des supports 17 par leurs extrémités supérieures et inférieures et que des couplages du champ magnétique avec les supports soient évités à l'endroit des espacements 15 et aux extrémités des colonnes. Les supports 17 ont donc avantageusement des bords supérieurs et inférieurs inclinés, comme les bords correspondants et adjacents des blocs ferromagnétiques 14.

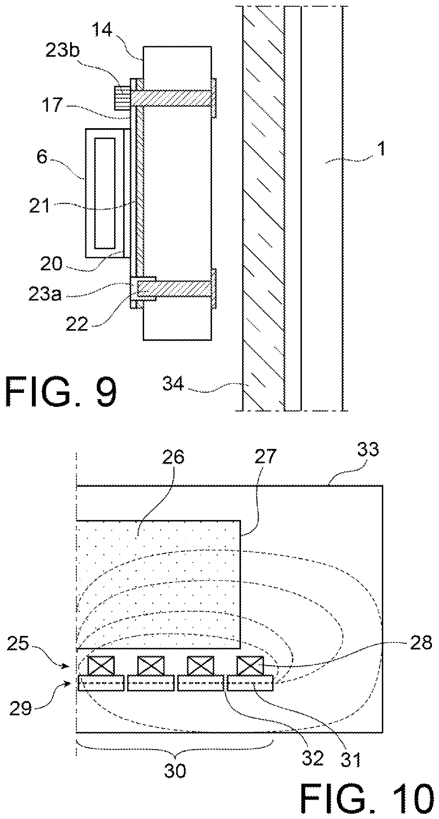

Les supports 17, de même que les autres constituants des assemblages permettant de soutenir des blocs ferromagnétiques 14 par les brins 6, sont de préférence conçus pour permettre une conduction thermique entre les brins 6 et les blocs ferromagnétiques 14, mais au contraire une isolation électrique, afin à la fois de favoriser le refroidissement des blocs ferromagnétiques 14 par le fluide de refroidissement circulant dans les brins 6 et d'éviter des pertes Joule supplémentaires dans les blocs ferromagnétiques 14 par passage de courant électrique avec les brins 6 ou tout autre élément conducteur de l'électricité soumis à des forces électromotrices. Un dispositif schématique, représenté à la figure 9, peut comprendre encore un brasage 20, ou un autre liant thermique et mécanique, entre la face intérieure 18 des supports 17 et les brins 6, une colle époxy 21 ou un autre liant thermique et donc de préférence isolant électrique entre la face extérieure 19 du support 17 et les blocs ferromagnétiques 14, et des vis 22, en appui sur la face extérieure des blocs ferromagnétiques 14, s'étendant le long de leurs faces latérales et boulonnées dans des bossages 23a des supports 17 ou des écrous 23b situés derrière eux, du côté de l'inducteur 12. Le maintien en position des blocs ferromagnétiques 14 est alors obtenu, la retenue en position verticale étant assurée surtout par l'adhérence de la couche de liaison 21. En variante, les vis 22 pourraient traverser les blocs ferromagnétiques 14 pour assurer aussi cette fonction. D'autres genres de supports seraient envisageables pour accomplir ces fonctions de maintien en place. En variante, le dispositif pourrait comprendre des supports non représentés dotés de bordures inférieures ou latérales permettant de poser les blocs ferromagnétiques 14 sur eux et de remplacer ainsi certaines au moins des vis 22 ou bien de s'affranchir de la propriété adhérente de la couche de liaison 21. Le dispositif de la figure 9 présente néanmoins l'avantage de réduire la superficie en regard des supports 17 et des blocs ferromagnétiques 14 et de construire plus facilement des supports 17 en matière métallique, en évitant donc les contacts électriques avec les blocs ferromagnétiques 14 par la couche de liaison 21 facile à poser.

La figure 9 montre encore qu'un matériau isolant électrique 34 en couche peut être intercalé entre le concentrateur de champ 12 et l'enveloppe extérieure 1, s'ils sont proches l'un de l'autre, puisqu'une canalisation suffisante du champ magnétique dans les blocs ferromagnétiques 14 peut permettre un tel rapprochement, avantageux pour réduire l'encombrement du dispositif, à condition de maintenir l'isolation électrique entre les deux constituants du blindage.

L'invention pourrait être mise en oeuvre d'autres façons, et notamment avec des inducteurs non cylindriques. La figure 10 représente une telle variante, où un inducteur plat 25 remplace l'inducteur précédent et se trouve sous la charge à chauffer 26, placée comme auparavant dans un creuset 27 cylindrique pouvant être un creuset froid. Les brins 28 de l'inducteur 25 peuvent être parallèles entre eux ou être placés comme dans la réalisation envisagée précédemment, en développant les nappes sur un plan. Le concentrateur de champ 29 est constitué de colonnes 30 perpendiculaires à la direction d'ensemble des brins 28, et elles sont composées, comme précédemment, de blocs ferromagnétiques 31, pouvant chacun être associés à un des brins 28 se trouvant en face de lui, et séparés par des espacements 32. Les principes de construction du concentrateur de champ 29 s'appliquent donc à volonté à de tels inducteurs. L'enveloppe extérieure 33 s'étend sous l'inducteur 25 et le concentrateur de champ 29, préférentiellement tout autour du dispositif et au-dessus du creuset 27. On a représenté les lignes de champ magnétique qui restent enfermées à l'intérieur de l'enveloppe 33 ou sont canalisées par les colonnes 30 de ferrite.

Certains bénéfices de l'invention sont les suivants :
- confinement amélioré du champ magnétique, en réduisant l'amplitude du champ à l'extérieur du blindage d'un facteur pouvant atteindre 40 par rapport à un agencement à colonnes ferromagnétiques de même masse et même disposition mais continues dans l'alignement des lignes de champ magnétique, dépourvues des espacements 15, et en l'absence d'enveloppe extérieure ;
- masse totale du blindage réduite d'un facteur pouvant être égal à 4 par rapport à un blindage composé exclusivement de matière ferromagnétique à atténuation égale des fuites de champ magnétique vers l'extérieur ;
- encombrement radial divisé d'un facteur 2 par rapport à un blindage doté uniquement d'une enveloppe métallique sans dispositif de refroidissement particulier ;
- décalage inférieur à ± 10 % des paramètres électriques vus par l'alimentation électrique de l'inducteur par rapport à une configuration sans blindage ;
- déséquilibre de ± 20 % environ des courants passant par les différents brins de l'inducteur équipé du blindage, au lieu de ± 97 % environ pour un agencement à spire unique à brins parallèles non entrecroisés.

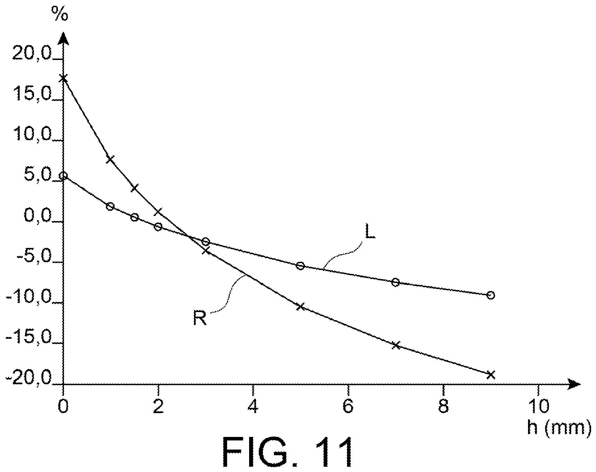

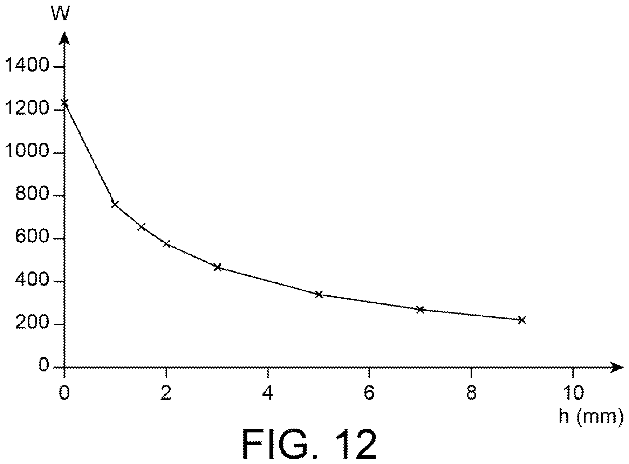

Cela sera illustré par les dernières figures. La figure 11 illustre l'effet d'une réalisation plausible de l'invention sur les paramètres électriques de résistance et d'inductance du dispositif vus par l'alimentation électrique de l'inducteur (fonctionnant par exemple à 3000 V et 300 kHz, pour une puissance active de 300 kW dans un inducteur de 0,8 m de diamètre et 0,6 m de hauteur, composé de quatorze brins 6 entrecroisés en alimentation parallèle et un agencement de ferrite tel que décrit ci-avant ayant une perméabilité magnétique relative de 4000), en pourcentages d'écart avec les paramètres valides pour la même réalisation sans blindage, d'après la hauteur des séparations entre les blocs ferromagnétiques 14, c'est-à-dire l'épaisseur des espacements 15, exprimées en millimètres en abscisses. Une plage de valeurs intéressante pour appliquer l'invention d'après le critère de maintien des paramètres électriques de l'installation s'étend d'environ 1mm à 4mm, entre lesquelles la résistance R varie entre ± 8 % au maximum, et l'inductance L varie de +2 % à -4 % au maximum. Le résultat peut être comparé à celui qu'on peut tirer de la figure 12, qui indique l'évolution des pertes thermiques dans l'assemblage de ferrite en watts d'après le même paramètre d'épaisseur des espacements 15. La baisse de ces pertes est immédiate dès que des espacements 15 sont installés, et d'autant plus grande que leur épaisseur est importante ; les incréments d'épaisseur ont toutefois de moins en moins d'effet à mesure que les épaisseurs auxquelles ils s'ajoutent sont plus grandes. Dans cette réalisation, une baisse des pertes de 40 % environ est déjà obtenue pour des épaisseurs de 1mm, et une baisse de 70 % environ pour des épaisseurs de 4mm. On peut considérer que la plage de valeurs avancée ci-dessus reste satisfaisante d'après ce deuxième critère. Le phénomène physique contrôlé et ajusté grâce à la présence des espacements 15 est une variation de la réluctance magnétique des colonnes 13 de ferrite ici verticales, c'est-à-dire leur capacité à capter du flux magnétique. Une approximation de l'augmentation de la réluctance dans une colonne peut s'exprimer en valeur absolue (unités en système international) par : deltaR = 1/µ * e/S * nEsp avec : deltaR, augmentation de la réluctance ; µ, perméabilité magnétique dans l'espacement 15 ; e : dimension de l'espacement 15 dans la direction des lignes de champ ; S, section de passage des lignes de champ dans la colonne 13 ; nEsp, nombre d'espacements 15 le long de la colonne 13. La réluctance globale du blindage peut aussi être estimée à l'aide d'une expression comprenant les réluctances unitaires de chaque constituant traversé par les lignes de champ magnétique, formulée d'après les lois usuelles de calcul des réluctances dans les circuits magnétiques.

## Revendications

1. Inducteur électromagnétique blindé, comprenant un inducteur disposé devant une charge à chauffer par induction électromagnétique et composé d'au moins une spire conductrice, où du courant circule dans une direction de longueur de spire, et un blindage électromagnétique comprenant un concentrateur de champ (12) magnétique disposé devant l'inducteur (3), avec l'inducteur entre ledit concentrateur de champ (12) et la charge, ledit concentrateur comprenant des colonnes (13) ferromagnétiques, dont une direction principale d'allongement coïncide avec une direction d'une composante principale de lignes de champ magnétique propagées par l'inducteur (3) d'un côté orienté vers le concentrateur de champ (12), **caractérisé en ce que** les colonnes sont séparées les unes des autres par un milieu isolant électrique et embrassent chacune une portion de longueur de spire de l'inducteur, **en ce que** les colonnes (13) sont composées d'éléments ferromagnétiques (14) se succédant dans ladite direction d'allongement et séparés par des espacements (15) isolants électriques, de plus faible perméabilité magnétique et de plus petite longueur que les éléments ferromagnétiques dans ladite direction d'allongement, et **en ce que** le blindage électromagnétique comprend encore une enveloppe (1) conductrice de l'électricité, le concentrateur de champ étant situé entre ladite enveloppe et l'inducteur.

2. Inducteur électromagnétique blindé suivant la revendication 1, **caractérisé en ce que** les éléments ferromagnétiques (14) sont en ferrite.

3. Inducteur électromagnétique blindé selon la revendication 1 ou 2, **caractérisé en ce que** l'inducteur a une forme de révolution autour de la charge et autour d'un axe (X), la direction d'allongement des colonnes (13) coïncide avec la direction de l'axe, et l'enveloppe (1) conductrice de l'électricité comprend une portion en forme de révolution autour de l'axe, qui entoure le concentrateur de champ (12).

4. Inducteur électromagnétique blindé suivant l'une quelconque des revendications précédentes, **caractérisé en ce que** lesdits espacements (15) sont dimensionnés de façon à augmenter la réluctance totale du blindage d'un facteur 20 à 80 (14).

5. Inducteur électromagnétique blindé suivant l'une quelconque des revendications précédentes, **caractérisé en ce que** l'inducteur (3) est à spire unique et la spire est composée de brins (6) alimentés en parallèles électriquement.

6. Inducteur électromagnétique blindé suivant les revendications 3 et 5, **caractérisé en ce que** les brins se composent de portions (7,8) inclinées dans la direction de l'axe, alternativement descendantes et ascendantes et réparties en deux nappes (9, 10) circulaires, concentriques et s'étendant à des hauteurs identiques suivant l'axe, une première des nappes comprenant toutes les portions ascendantes et une seconde des nappes toutes les portions descendantes.

7. Inducteur électromagnétique blindé suivant l'une quelconque des revendications 5 ou 6, **caractérisé en ce que** les éléments ferromagnétiques (14) s'étendent chacun devant un seul des brins (6) de l'inducteur (3), ou une seule des portions descendantes ou ascendantes de celle des nappes qui est radialement plus à l'extérieur si la spire est composée desdites portions dans lesdites nappes concentriques.

8. Inducteur électromagnétique blindé suivant l'une quelconque des revendications précédentes, **caractérisé en ce que** l'inducteur (3) est refroidi par une circulation interne de fluide.

9. Inducteur électromagnétique blindé suivant l'une quelconque des revendications précédentes, **caractérisé en ce que** les éléments ferromagnétiques (14) sont montés sur l'inducteur par des liaisons de support (17, 20, 21, 22).

10. Inducteur électromagnétique blindé suivant les revendications 8 et 9, **caractérisé en ce que** les liaisons de support sont globalement conductrices thermiques et isolantes de l'électricité entre les éléments ferromagnétiques (14) et l'inducteur (3), et les éléments ferromagnétiques sont dépourvus de circuit de fluide de refroidissement particulier.

11. Inducteur électromagnétique blindé selon la revendication 10, **caractérisé en ce que** les liaisons de support comprennent chacune une pièce adaptative (17) dont un premier côté (18) a une courbure identique à l'inducteur et est relié à l'inducteur par une couche de liaison (20), et un deuxième côté (19), opposé au premier côté, sur lequel au moins un élément ferromagnétique (14) est installé et qui a une courbure identique audit au moins un élément ferromagnétique.

12. Inducteur électromagnétique blindé selon la revendication 11, **caractérisé en ce que** ledit élément ferromagnétique installé est lié aux pièces adaptatives par une seconde couche de liaison (21).

13. Inducteur électromagnétique blindé selon l'une quelconque des revendications 11 ou 12, **caractérisé en ce que** les liaisons de support comprennent des vis (22) de fixation des éléments ferromagnétiques (14) à la pièce adaptative (17).

14. Inducteur électromagnétique blindé selon l'une quelconque des revendications 10 à 13, **caractérisé en ce que** les supports ont une extension moindre que les éléments ferromagnétiques (14) dans ladite direction d'allongement, et les éléments ferromagnétiques (14) ont des bords extrêmes dans la direction d'allongement qui sont dégagés des supports.

15. Inducteur électromagnétique blindé selon l'une quelconque des revendications précédentes, **caractérisé en ce que** les éléments ferromagnétiques (14) sont des blocs ou des tuiles en forme de quadrangles plats, chanfreinés ou dotés de congés de raccordement (16) à au moins certains coins du quadrangle.

16. Inducteur électromagnétique blindé selon l'une quelconque des revendications précédentes, **caractérisé en ce que** le concentrateur de champ (12) est séparé de l'enveloppe conductrice (1) par une couche d'isolant électrique (24).

17. Utilisation de l'inducteur électromagnétique blindé selon l'une quelconque des revendications précédentes dans un four pour vitrifier des déchets nucléaires.

## Patentansprüche

1. Abgeschirmter elektromagnetischer Induktor, umfassend einen Induktor, der vor einer durch elektromagnetische Induktion zu erwärmenden Last angeordnet ist und aus mindestens einer leitenden Windung besteht, wobei Strom in einer Windungslängenrichtung fließt, und eine elektromagnetische Abschirmung, umfassend einen magnetischen Feldkonzentrator (12), der vor dem Induktor (3) angeordnet ist, wobei sich der Induktor zwischen dem Feldkonzentrator (12) und der Last befindet, wobei der Konzentrator ferromagnetische Säulen (13) umfasst, deren Hauptlängsrichtung mit einer Richtung einer Hauptkomponente von Magnetfeldlinien zusammenfällt, die von dem Induktor (3) auf einer Seite ausgebreitet werden, die dem Feldkonzentrator (12) zugewandt ist, **dadurch gekennzeichnet, dass** die Säulen durch ein elektrisch isolierendes Medium voneinander getrennt sind und jeweils einen Abschnitt der Windungslänge des Induktors umfassen, dass die Säulen (13) aus ferromagnetischen Elementen (14) bestehen, die in der Längsrichtung aufeinander folgen und durch elektrisch isolierende Abstände (15) voneinander getrennt sind, dass die elektromagnetische Abschirmung ferner eine elektrisch leitende Hülle (1) umfasst, wobei der Feldkonzentrator zwischen der Hülle und dem Induktor angeordnet ist.

2. Abgeschirmter elektromagnetischer Induktor nach Anspruch 1, **dadurch gekennzeichnet, dass** die ferromagnetischen Elemente (14) aus Ferrit bestehen.

3. Abgeschirmter elektromagnetischer Induktor nach Anspruch 1 oder 2, **dadurch gekennzeichnet, dass** der Induktor eine Rotationsform um die Last und um eine Achse (X) aufweist, die Längsrichtung der Säulen (13) mit der Richtung der Achse zusammenfällt, und die elektrisch leitende Hülle (1) einen Abschnitt umfasst, der eine Rotationsform um die Achse aufweist, die den Feldkonzentrator (12) umgibt.

4. Abgeschirmter elektromagnetischer Induktor nach einem der vorstehenden Ansprüche, **dadurch gekennzeichnet, dass** die Abstände (15) so bemessen sind, dass sie den Gesamtreluktanz der Abschirmung um einen Faktor 20 bis 80 (14) erhöhen.

5. Abgeschirmter elektromagnetischer Induktor nach einem der vorstehenden Ansprüche, **dadurch gekennzeichnet, dass** der Induktor (3) eine einzige Windung aufweist und die Windung aus elektrisch parallel gespeisten Strängen (6) besteht.

6. Abgeschirmter elektromagnetischer Induktor nach den Ansprüchen 3 und 5, **dadurch gekennzeichnet, dass** die Stränge aus Abschnitten (7, 8) bestehen, die in Richtung der Achse geneigt sind, abwechselnd abwärts und aufwärts verlaufen und in zwei kreisförmige, konzentrische Matten (9, 10) aufgeteilt sind, die sich in gleicher Höhe entlang der Achse erstrecken, wobei eine erste der Matten alle aufwärts verlaufenden Abschnitte und eine zweite der Matten alle abwärts verlaufenden Abschnitte aufweist.

7. Abgeschirmter elektromagnetischer Induktor nach einem der Ansprüche 5 oder 6, **dadurch gekennzeichnet, dass** die ferromagnetischen Elemente (14) sich jeweils vor nur einem der Stränge (6) des Induktors (3) oder nur einem der absteigenden oder aufsteigenden Abschnitte derjenigen der Matten erstrecken, die radial weiter außen liegt, wenn die Windung aus diesen Abschnitten in den konzentrischen Matten besteht.

8. Abgeschirmter elektromagnetischer Induktor nach einem der vorstehenden Ansprüche, **dadurch gekennzeichnet, dass** der Induktor (3) durch einen internen Fluidkreislauf gekühlt wird.

9. Abgeschirmter elektromagnetischer Induktor nach einem der vorstehenden Ansprüche, **dadurch gekennzeichnet, dass** die ferromagnetischen Elemente (14) über Stützenverbindungen (17, 20, 21, 22) an dem Induktor angebracht sind.

10. Abgeschirmter elektromagnetischer Induktor nach Anspruch 8 und 9, **dadurch gekennzeichnet, dass** die Stützen allgemein wärmeleitend und elektrisch isolierend zwischen den ferromagnetischen Elementen (14) und dem Induktor (3) sind und die ferromagnetischen Elemente keinen besonderen Kühlmittelkreislauf haben.

11. Abgeschirmter elektromagnetischer Induktor nach Anspruch 10, **dadurch gekennzeichnet, dass** die Stützen jeweils ein adaptives Teil (17) umfassen, dessen erste Seite (18) eine identische Krümmung wie der Induktor aufweist und mit dem Induktor durch eine Verbindungsschicht (20) verbunden ist, und eine zweite Seite (19), die der ersten Seite gegenüberliegt, auf der mindestens ein ferromagnetisches Element (14) installiert ist, und die eine identische Krümmung wie das mindestens eine ferromagnetische Element aufweist.

12. Abgeschirmter elektromagnetischer Induktor nach Anspruch 11, **dadurch gekennzeichnet, dass** das installierte ferromagnetische Element mit den adaptiven Teilen durch eine zweite Verbindungsschicht (21) verbunden ist.

13. Abgeschirmter elektromagnetischer Induktor nach einem der Ansprüche 11 oder 12, **dadurch gekennzeichnet, dass** die Stützenverbindungen Schrauben (22) zur Befestigung der ferromagnetischen Elemente (14) an dem adaptiven Teil (17) umfassen.

14. Abgeschirmter elektromagnetischer Induktor nach einem der Ansprüche 10 bis 13, **dadurch gekennzeichnet, dass** die Stützen eine geringere Ausdehnung als die ferromagnetischen Elemente (14) in der Längsrichtung aufweisen, und die ferromagnetischen Elemente (14) Endkanten in der Längsrichtung aufweisen, die von den Stützen freiliegen.

15. Abgeschirmter elektromagnetischer Induktor nach einem der vorstehenden Ansprüche, **dadurch gekennzeichnet, dass** die ferromagnetischen Elemente (14) Blöcke oder Dachziegel in Form von flachen Vierecken sind, die abgeschrägt sind oder an mindestens einigen Ecken des Vierecks mit Verbindungskegeln (16) versehen sind.

16. Abgeschirmter elektromagnetischer Induktor nach einem der vorstehenden Ansprüche, **dadurch gekennzeichnet, dass** der Feldkonzentrator (12) durch eine elektrisch isolierende Schicht (24) von der leitenden Hülle (1) getrennt ist.

17. Verwendung des abgeschirmten elektromagnetischen Induktors nach einem der vorstehenden Ansprüche in einem Ofen zur Verglasung von nuklearem Abfall.

## Claims

1. A shielded electromagnetic inductor, comprising an inductor arranged in front of a load to be heated by electromagnetic induction and composed of at least one conductive turn, where current flows in a turn length direction, and an electromagnetic shielding comprising a magnetic field concentrator (12) arranged in front of the inductor (3), with the inductor between said field concentrator (12) and the load, said concentrator comprising ferromagnetic columns (13), a main direction of elongation of which coincides with a direction of a main component of magnetic field lines propagated by the inductor (3) on a side oriented to the field concentrator (12), **characterized in that** the columns are separated from each other by an electrically insulating medium and each embrace a portion of turn length of the inductor, **in that** the columns (13) are composed of ferromagnetic elements (14) succeeding each other in said direction of elongation and separated by electrically insulating gaps (15), having lower magnetic permeability and shorter length than the ferromagnetic elements in said direction of elongation, and **in that** the electromagnetic shielding further comprises an electrically conductive casing (1), the field concentrator being located between said casing and the inductor.

2. The shielded electromagnetic inductor according to claim 1, **characterised in that** the ferromagnetic elements (14) are of ferrite.

3. The shielded electromagnetic inductor according to claim 1 or 2, **characterised in that** the inductor has a rotational shape about the load and about an axis (X), the direction of elongation of the columns (13) coincides with the direction of the axis, and the electrically conductive casing (1) comprises a portion with a rotational shape about the axis, which surrounds the field concentrator (12).

4. The shielded electromagnetic inductor according to any of the preceding claims, **characterised in that** said gaps (15) are dimensioned so as to increase the total reluctance of the shielding by a factor of 20 to 80 (14).

5. The shielded electromagnetic inductor according to any of the preceding claims, **characterised in that** the inductor (3) is a single turn inductor and the turn is composed of electrically parallel supplied strands (6).

6. The shielded electromagnetic inductor according to claims 3 and 5, **characterised in that** the strands are composed of portions (7, 8) tilted in the direction of the axis, alternately descending and ascending and distributed in two circular, concentric plies (9, 10) extending at identical heights along the axis, a first of the plies comprising all the ascending portions and a second of the plies all the descending portions.

7. The shielded electromagnetic inductor according to any one of claims 5 or 6, **characterised in that** the ferromagnetic elements (14) each extend in front of only one of the strands (6) of the inductor (3), or only one of the descending or ascending portions of that one of the plies which is radially outermost if the turn is composed of said portions in said concentric plies.

8. The shielded electromagnetic inductor according to any of the preceding claims, **characterised in that** the inductor (3) is cooled by an inner fluid circulation.

9. The shielded electromagnetic inductor according to any of the preceding claims, **characterised in that** the ferromagnetic elements (14) are mounted to the inductor by support linkages (17, 20, 21, 22).

10. The shielded electromagnetic inductor according to claims 8 and 9, **characterised in that** the support linkages are overall thermally conductive and electrically insulating between the ferromagnetic elements (14) and the inductor (3), and the ferromagnetic elements are devoid of a particular cooling fluid circuit.

11. The shielded electromagnetic inductor according to claim 10, **characterised in that** the support linkages each comprise an adaptive part (17), a first side (18) of which has a curvature identical to the inductor and is connected to the inductor through a linking layer (20), and a second side (19), opposite to the first side, on which at least one ferromagnetic element (14) is installed and which has a curvature identical to said at least one ferromagnetic element.

12. The shielded electromagnetic inductor according to claim 11, **characterised in that** said installed ferromagnetic element is linked to the adaptive parts through a second linking layer (21).

13. The shielded electromagnetic inductor according to any one of claims 11 or 12, **characterised in that** the support linkages comprise screws (22) for attaching the ferromagnetic elements (14) to the adaptive part (17).

14. The shielded electromagnetic inductor according to any one of claims 10 to 13, **characterised in that** the supports have less extension than the ferromagnetic elements (14) in said direction of elongation, and the ferromagnetic elements (14) have end edges in the direction of elongation that are clear of the su pports.

15. The shielded electromagnetic inductor according to any of the preceding claims, **characterised in that** the ferromagnetic elements (14) are blocks or tiles in the form of flat quadrangles, chamfered or provided with fillets (16) at least at some corners of the quadrangle.

16. The shielded electromagnetic inductor according to any of the preceding claims, **characterised in that** the field concentrator (12) is separated from the conductive casing (1) through a layer of electrical insulator (24).

17. Use of the shielded electromagnetic inductor according to any of the preceding claims in a furnace for vitrifying nuclear waste.
